# EUROPEAN PATENT APPLICATION

(11) **EP 2 669 173 A1**
(43) Date of publication of application: **04.12.2013**
(21) Application number: 12170506.5
(22) Date of filing: 01.06.2012
(51) Int. Cl.: B63B 9/00

(54) **Method and system for evaluation of ship performance**

(71) Applicant: ABB Technology AG, 8050 Zürich (CH)
(72) Inventor: Tervo, Kalevi, 00980 Helsinki (FI)
(74) Representative: Söderman, Lisbeth Karin

(57) **Abstract**

This invention provides a computer-implemented method and a system for evaluation of the performance of a ship. In the method, one or more performance variables of a ship and dynamic input parameters that affect to the performance variables are defined. The dependencies between the performance variables and the dynamic input parameters are then learned automatically by means of computing. An initial model for simulating the performance of the ship is created by means of said dependencies between the performance variables and the dynamic input parameters in said initial model. Measurement results from sensors are obtained during the operation of the ship for producing a set of new dynamic input parameters to be used in the model instead of the foregoing input parameters used in said initial model. The initial model is updated to be used as the model in further operation and further updating the model until the model meets preset quality criteria for a model to be used. The updated model is used to analyze the impact of a given input parameter to one or more of the performance variables. The invention is also concerned with a system and a computer program for performing such a method.

## Description

### TECHNICAL FIELD

The invention is concerned with a method and system for evaluation of the performance of a ship.

### BACKGROUND

In a seagoing vessel or a ship, fuel, like oil or sometimes natural gas, is used as an energy source for one or more diesel engines that rotate generators or the main propellers of the vessel. The fuel is delivered to the marine vessel in the harbors or during the voyage by fuel tankers.

The power production and propulsion system have been targets for continuous adjustment, control and monitoring in order to achieve optimal efficiency with respect to the performance of the ship. The power control is a fundamental part of the control system of a ship. Likewise, the propulsion system is controlled to produce the required power by using the available electric and/or primary energy. In practice, however, the sufficiency of energy has not been as critical as the efficiency of the devices and their control systems.

By controlling the power of the separate devices on board, energy can be consumed efficiently and economically. This applies e.g. for individual propulsion units, pumping devices, lighting and heating equipments and other auxiliary devices.

Also a lot of other factors affect the overall energy efficiency of the marine vessel and should be taken into consideration in the ship performance including optimization and configuration of the power plant of the ship, choice of fuel type, the trim and list of the ship and the planned route.

A computer simulation or a computer model is a computer program that attempts to simulate an abstract model of a particular system. Optimization of ship performance, like energy consumption, has been performed by creating such computer-implemented simulation models that describe relationships and dependencies between operational variable factors of the ship and parameters presenting input variables that these factors depend on. The models enable prediction of the behaviour of the system from a set of parameters and initial conditions.

An example of such model using is a solution for efficient energy control based on design data that is presented in WO publication 2011/161211. It discloses an example of a method and arrangement for controlling energy consumption in a marine vessel on the basis of different input data, such as operational data, route data, weather forecast and different environmental factors. Also data related to the fuel itself, like fuel type, fuel costs etc. are taken into consideration. The energy balance of the energy consuming devices is managed on the basis of a calculated prediction that is based on said input data.

WO publication 2007/017908 presents a design tool to increase the efficiency of ship design by making it possible for designers to employ tools that assist in the design of ships. The design tool is also used to optimize the operational cost of the ship in operation by receiving signals from sensors and simulating the operation according to the sensor information and adjust the energy system accordingly. The publication is an improvement in view of solutions relying only on design data in that it also takes sensor information into consideration for controlling the energy balance during operation.

The reliability and the trust that can be put in such computer simulations depend on the validity of the simulation model.

Modeling the dependencies between the performance variable and the affecting input variables are complicated and based on empirical methods. Prior art methods require human effort and manual setting of parameters.

In addition, the models are insufficient in giving information about how individual factors influence on the total performance.

In performance evaluation systems an important issue would be to provide the user not only with information of the current state of the whole system, but also to give a reference which evaluates the performance with respect to selected operating conditions.

The object of this invention is to develop simulation models that give more detailed and reliable information about different factors affecting the ship performance.

### TERMS USED IN THE APPLICATION

The following terms are used in the application text
TRIM: The floating inclination of the ship in the longitudinal (pitch) direction, i.e. the difference between the sinkage of the fore and aft of the ship.
LIST: The floating inclination of the ship in the transversal (roll) direction.
DRAFT: The midship sinkage of the ship.
FLOATING POSITION: Trim, draft or list or any combination of trim, draft and list. The floating position affects the displacement, wet surface and the water resistance of the ship.
POWER PLANT CONFIGURATION: The sharing/distribution of the load between different power generation and consuming devices (like diesel generators, shaft generators, waste heat recovery systems, etc.).
OPTIMAL POWER PLANT CONFIGURATION: The distribution of load between different power generation and consuming devices that fulfills the optimization criteria such as fuel consumption, emissions, etc.
SHIP BEHAVIOUR/SHIP PERFORMANCE: Describes the actual function of the ship including e.g. the movement, energy consumption, fuel consumption, and emissions of the ship.
SHIP OPERATION: Describes the maneuvering and steering and control actions of the ship in order to drive the engines and electrical devices and move the ship.
VESSEL used synonymously with SHIP
SEA STATE: The state of the sea determined by the wave height, wave period, wave direction, swell, wind-induced waves, etc.

### SUMMARY OF THE INVENTION

This invention provides a computer-implemented method and a system for evaluation of the performance of a ship. In the method, one or more performance variables of a ship and dynamic input parameters that affect to the performance variables are defined. The dependencies between the performance variables and the dynamic input parameters are then learned automatically by means of computing. An initial model for simulating the performance of the ship is created by means of said dependencies between the performance variables and the dynamic input parameters in said initial model. Measurement results from sensors are obtained during the operation of the ship for producing a set of new dynamic input parameters to be used in the model instead of the foregoing input parameters used in said initial model. The initial model is updated to be used as the model in further operation and further updating the model until the model meets preset quality criteria for a model to be used. The updated model is used to analyze the impact of a given input parameter to one or more of the performance variables.

The system of the invention defines a learning algorithm that takes training data as input, which in making the initial model might base on earlier knowledge to constitute the primary input data. In the updating of the model, the set of new input data from sensor signals are used as new training data in stead of the data used in the initial model. The learning algorithm outputs a model from the training data after learning how the input parameters affect on the performance variable. The model contains the dependency definitions between the parameter sets and the performance variable as well as possible feature specifications. The learning algorithm is generic and will produce different models when different training data is given as input.

The preferable embodiments of the invention have the characteristics of the subclaims.

In creating the model, the invention uses computational learning methods for dependency definition.

Thus, the model continues improving itself until it meets the predefined completion and quality criteria. The stopping criteria can include e.g. the range of variation of an input signal compared against the expected range of variation of the signal, additional information content of the new input data compared to the data seen previously, the prediction performance of the model, statistical significance of the model parameters, statistical significance of the amount of data, etc. The model also monitors the quality of input data such as it evaluates the reliability of a measurement signals based on the dynamics of the difference between the predicted and measured values, as well as the behavior of the input signals. In addition, the mutual dependencies between the input signals and the output signals can be monitored by the model, and if dependencies between the measured input signals change, the model is able to estimate the quantity based on the measurement history, the current values. In addition to the estimation, once the model has been trained, it is possible to recognize the breakdown of sensors by using the model.

In the quality control, the relation between the measurements, the own dynamic of the measurement and physical variations of the measurements are monitored. This can be exemplifies by means of e.g. the speed of the ship. The ship is a very big entirety and its speed can not change very fast. The model can take impossible changes and changes of no sense or differences defined to be too big into consideration by comparing the speed measurement to the foregoing state of the ship and to other measurements an make a decision if the measurement can be trusted or not. If the measurement can not be trusted the model can decide e.g. to ignore it.

Another example is related to measurement errors. The maximum speed of the ship is known and if a measurement value e.g. exceeds that it can be a physically impossible value and can be deleted from training data. By using the model, these measurements can be ignored or it can be estimated to be some other value on the basis of information and dynamics from other measurements, foregoing values, the relationships describing the measurements.

The algorithm instructs the computer to evolve behaviors based on empirical data, such as from sensor data or databases in order to define dependencies between the performance variable and the dynamic input parameters from the sensors. The dependencies are learned automatically by means of computing in order to recognize patterns and by making useful outputs along with new input data fed to the system. As the behaviours are based on empirical data, typically recorded from a complex multidimensional system, the dependencies are usually multidimensional and non linear.

Earlier knowledge can be made use of to capture characteristics of interest of the unknown underlying probability distribution of the characteristics. Primary input data can consist of examples of relations between observed variables. As a result of the learning a function is generated that maps inputs to desired outputs.

It is very typical in marine applications that the performance of the equipment of the ship varies significantly more with respect to the operating conditions than with respect to the poor operation. For example, on deep sea, the greatest variation in the vessel's propulsion power comes from the vessel's speed as well as wind, weather and waves. These operating conditions need to be taken into account when evaluating the performance.

This invention provides a solution for evaluation that takes the real conditions during operation into account for evaluating the ship performance and the influence of individual factors on the performance.

An essential idea in this invention is that each performance variable can be shown as a trend or a number that is given in relation to a reference that takes into account the operating conditions affecting the variable. This can e.g. be done by presenting a target for the performance variable that is based on the variation range of a variable in the given circumstances.

When trying to evaluate the performance of equipment based on real data collected during the operation of the ship, it is difficult to isolate the impact of one particular condition factor form all other changing conditions due to the multidimensional and non linear relationships. With equipment is meant any apparatus or device from which measurements are obtained, e.g. the machines for producing refrigeration, the power need of which depends on circumstances and situation, the propulsion system of the ship, the power of which depends on e.g. speed, wind, and the draft.

This invention uses a normalization method for removing the impact of various conditional factors of performance measurements so that the effect of different conditions can be evaluated. The invention can also be used to check whether the system is being operated efficiently as well as to evaluate the performance of a device with respect to the measured dynamic parameters.

Data is modified by means of normalization by taking circumstances and other factors into account in measured data, so that performance degradation due to bad operation or a gradual failure could be recognized.

Current prior art solutions for evaluation ship performance do not provide methods for isolating desired conditional impact factors from all factors impacting the modelled performance of the ship.

The invention thus provides several advantages compared to the systems of prior art, like automatic learning of the dependencies between different input data and given performance variables. Furthermore, the effect of the input values to the performance variable can be evaluated.

The invention also provides a practice and simplified modelling solution for ship performance by means of a self learning algorithm and by normalizing data so that the impact of individual factors can be predicted. The normalization of performance and condition measurements is performed by removing the impact of selected external conditions from the model.

Still further, the invention provides visibility on how the performance of the system is affected by equipment conditions, equipment tuning state and/or the way of using the equipment.

The developed systems normalize any performance variable with respect to any given condition to a comparable state on a marine vessel. The normalized condition can be used for reliable comparison, between vessels, between the equipments on the vessel or between current and previous state of equipment or of vessel.

When the effect of different circumstances and conditions has been normalized from the measurements, ships running in different conditions can be compared to eachother. Similar apparatuses in one ship or in other ships can be compared when different conditions and operating points are taken into account.

The model can be used to predict the conditional distribution of the performance by making use of a conditional probability distribution. An expected value for the performance variable can be predicted and its variation range in conditional (e.g. fixed, measured, current) circumstances.

The degradation of an individual apparatus or device can be recognized when the model is not trained anymore. Since the model gives a reference or variation range or a target for the performance variable on the basis of obtained measurements it is possible to recognize if a deviation from the reference starts takes place in the long run. For instance, if the power consumption of a given device systematically deviates from the given reference or target in the measured circumstances, it can be suspected that there is something wrong with the device.

The current measured performance variable and the conditional distribution of the performance variable can be used to compute an index that is normalized with the parameters of the conditional distribution.

A lot of different variables influence on the performance of a ship on which the method of the invention can be implemented. The actual performance variable depends on the apparatus to be monitored. The energy consumption is one such variable. Other possible performance variables relate to e.g. the power consumption, time, pressure etc. Thus, the invention can e.g. be implemented for calculating the impact of the torque and rotation speed on the fuel consumption of the main engine in a single shaft mechanical shaftline vessel. The torque and rotation speed characterize the shaft power, which should have a mathematical relation in the fuel consumption of the main engine (taking into account the environmental conditions). If the relation changes, e.g. the main engine consumes systematically more than the model predicts, the engine might need maintenance.. If the motor vibrates more than predicted by the model at a given speed, it might be indication of that the bearings are worn. Yet another example might be the fuel consumption of the whole vessel as a function of the environmental conditions (weather, wind, waves, seawater temperature, humidity, etc.) and operational conditions (speed, draft, depth, etc.). If the vessel consumes more at the prevailing circumstances than predicted by the model, the cause can be poor operation of the vessel (processes, devices, etc.) as well as degraded performance of the equipment. In general, the performance value can be an object on process level (such as the total consumption required for ventilation), on apparatus level (the consumption of a n individual device) or on operation level (the energy consumption of the whole ship) or it can even be the consumption from point A to point B, the time etc. Different external conditions have an impact on different performance values, which can be taken into account in the creation of the model.

Thus, the invention can be implemented on any performance variable, the variation or change of which tells about degradation of the performance, settings or operation of the apparatus in constant conditions. The model based approach of the invention models the dependence the conditions for this performance variable, whereby the variation caused by bad operation, technical working condition of the apparatus are more apparent.

The essential idea is to define a performance value and the parameters that affect on that and to collect data of them all and to create a model describing the relationships between the model and the parameters. The model can then be used for normalization an to evaluate how good the performance of a system or a device described by the performance variable is.

In the following, the invention will be described by means of a detailed embodiment, wherein the energy consumption has bee taken as an example of the performance variable. The invention is in no way restricted the details of the embodiments of the figures since as was presented above many other embodiments are possible with the scope of the invention that is restricted by the main claims.

### FIGURES

Figure 1 presents an embodiment of the invention in the form of a block diagram
Figure 2 presents a flow scheme of the invention

### DETAILED DESCRIPTION

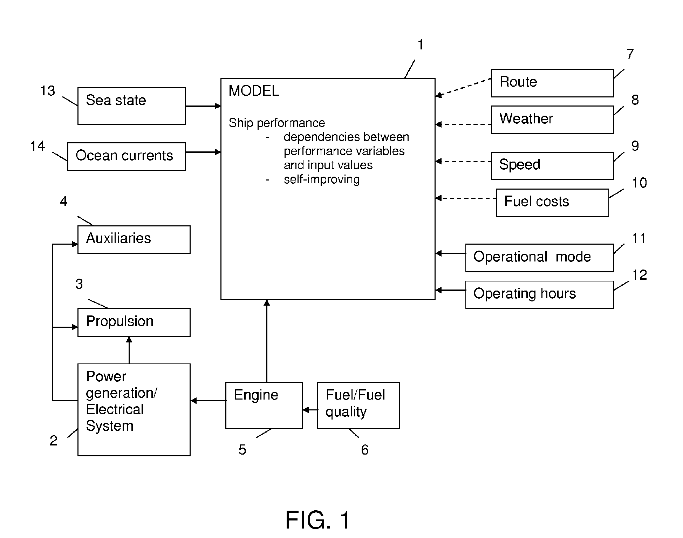

Figure 1 presents a particular embodiment of the invention in the form of a block diagram and illustrates the creation of the model of ship performance, wherein the energy consumption has been selected as performance variable. It shows how the conditions on board are taken into consideration in accordance with the idea of the invention to improve the model.

Energy consuming devices in the vessel are those relating to propulsion energy, whose duty is to move and guide the vessel from the port of departure to the port of destination. Other energy consuming devices are partially independent of the movement of the vessel, such as auxiliary devices for lighting, pumping, heating, ventilation, etc.

Several factors and parameters related to e.g. the energy consumption of a ship are taken into account in the practical operation of the ship as well as in the distribution of the energy load on different engines and auxiliary devices on board.

The energy consumption is determined not only by the co-action of the different devices but is also affected by external conditions during the operation of the ship, such as weather and sea currents, and sea depths, and by operational parameters, such as speed, emission targets, operating hours, and modes of operation like drive in harbour, open sea drive or maneuvering drive, which have different kind of demands.

In this invention, an initial simulation model is created for simulating the performance of the ship. The model defines relationships between factors related to the ship during operation (such as energy load and energy distribution) and parameters presenting dynamic input data that depend on said factors.

The block diagram of figure 1 consists of blocks that represent machines, sensors, control and management units, and data handling units. The arrows from the blocks describe the output of the blocks and the arrows to the block describe the input of the blocks.

The power generation/electrical system unit 2 generates the required electrical power for the need of the vessel and creates the propulsion power for the propellers. Thus, the power generation/electrical system unit supplies the energy to the propulsion unit 3 and to all the electric power consuming devices that are symbolized as the auxiliary unit 4.

In the creating of an initial simulation model for the ship performance, information from the power generation/electrical system unit 2 will be transferred to the processor unit 1 for creating the model to get all the basic data from load points to available power in order to find a model for the right energy balance on the system. E.g. the number of the generators is decided to produce the required power as efficiently as possible in the simulation model. Initial route information 7, such as ports data, and weather information 8, such as weather forecasts, sea current data 14, sea state13 and sea depths, is also taken into account in the creation of the initial model.

Ports data 7 give available information about the ports from the start point to the destination and of any intermediate points between these points. A route plan is created that considers input data and the external forces the marine vessel will face during the voyage from the start point to the end point will be calculated as well as an estimate for energy consumption to be used in the current operation of the ship.

It is also possible to take other than external forces into consideration in the creating of the initial model such as speed data of the ship 9, the operational mode 11 consisting of data and instructions that define the particulars according to which the marine vessel is operating, like e.g. open sea mode or port mode if these can be predicted in advance. The operating hours 12 define the duration of the different operational modes and their sequences and can also be used in the initial model. The fuel costs 10 give the fuel types and process to be used.

The fuel/fuel quality unit 6 has information of the available fuels and their characteristics in order to find the most efficient way of operation. The unit enables the engine to operate in an efficient way and taking the emission targets into account.

The simulation model 1 is continuously improved by utilizing fresh information continuously collected during the operation of the ship. Thus fresh information about route 7, weather 8, speed 9, fuel costs 10, operational mode 11 operating hours 12, emissions (not shown), engine 5, sea state 13 and ocean currents 14 are collected and fed as input for updating of the model 1.

Furthermore, the simulation model 1 can have input from the engine 3, which input consists of the efficiency curve of the power plant optimization. A speed/power report is generated based on the actual external forces the vessel operates in. The power per unit is a function of the speed of the vessel. The actual speed/power value will change several times during a voyage, for example when the vessel change course or come into shallow waters or sea-current changes.

The input from the engine 5 also consists of information of emissions, whereby the emissions of the engine is input to the model in order to compare the emissions with the emissions target set by rules or the authorities and limit the amount of the emissions below the target values.

Initial information about emissions and the efficiency curve might be taken into consideration also in creating the initial model being the base for the operation of the ship.

Input for the simulation model 1 can consist both of information of the current operation parameters for the operation of the ship and of actual conditions on board. Information of conditions on board is given by signals form sensors on board during the operation of the ship. The signals are directly received by a processor unit 1 that creates the model and processes input data and the signals are processed by the simulation model used in the system created to make use of fresh information of dynamic parameters influencing on the ship performance.

The obtained signals represent measurement results from sensors during the operation of the ship and are used for producing a set of new dynamic input data to be used in the updating of the simulation model. An optimized simulation result for the ship operation is then calculated by using said produced input data in the simulation model. The optimized simulation result is then compared with the actual ship operation that has been received as input from a control unit (not shown) in the system.

If the difference between the simulation result and the actual operation exceeds defined threshold criteria, the model is improved by redefining the relationships between the distribution of the load and dynamic input data, like external factors and factors related to the operation and emissions.

Said new input data is taken into consideration in the updating of the model in order to make an improved model. Said new input data as given by the sensors includes the same kind of input data that was used in creating the initial model before operation, i.e. weather 7 and route 8 data, ports data, the speed 9 of the vessel, the operational mode 10 of the vessel, info about operational hours 11, fuel costs 13, and the efficiency curve and emissions form the engine 3. Of course some input data may not have been changed. The model may have other inputs than mentioned here depending on case and actual conditions. In some embodiments all these inputs mentioned maybe are not used in the model. All variations belong to the scope of this invention.

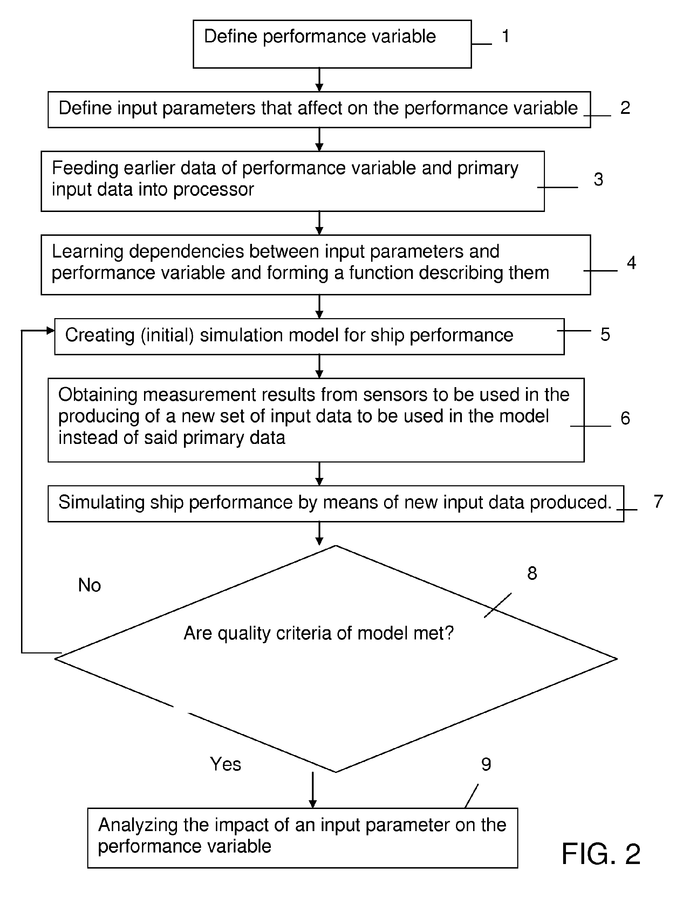

The model created in the invention can be utilized to analyze the impact of one or more selected input parameters to the performance variable. This is presented in more detail in figure 2.

Figure 2 presents the invention in the form of a flow scheme.

The invention makes use of a computer-implemented method for evaluation of the performance of a ship, and especially for evaluation of the impact of certain conditions or variable parameters on a certain performance variable or several performance variables. Such a performance variable can e.g. be the energy consumption of the equipment on the ship, fuel costs, or the energy distribution on the consumer devices on the ships or some other variable examples of which were mentioned in the summary section..

In the method, one or more performance variables of a ship and dynamic variable input parameters that might affect to the performance variable(s), are therefore defined in steps 1 and 2, respectively. Possible input parameters were presented in the connection with figure 1, such as information about the route, weather and sea data, the speed of the ship, fuel costs, information about the operational mode and the operating hours, and information from the engine in the form of energy consumption data, and information about emissions and target emissions.

Data of a predicted operation is then fed into the processor in step 3 as well as earlier data of the performance variable and primary input data.

For the creation of an initial simulation model, the system of the invention defines a learning algorithm that takes as input training data, which in making the initial model might as was said, base on earlier knowledge to constitute the primary input data and the performance variable that depends on said input data.

The algorithm then automatically learns the dependencies between the primary input parameters and the performance variable and can define a function that describe these dependencies in step 4 to be used in the creation of an initial simulation model.

An initial model for simulating the performance of the ship can then be created by the algorithm in step 5 by means of said dependencies between the performance variable and the primary input data to be used as dynamic input parameters in said initial model.

The processor obtains measurement results from sensors during the operation of the ship in step 6 for producing a set of new dynamic input data to be used in the model instead of said primary input data.

The model performance simulated in step 7 is compared to quality criteria in step 8. The comparison can take place by comparing the simulation result with the real operation of the ship and if the difference exceeds a preset threshold value and the set quality criteria for the model are not fulfilled as considered in step 8, the model is updated by repeating steps 5 - 8 until the quality criteria are met with the difference that in step 5, instead of creating an initial model now an updated model is created, i.e., the initial model is improved, by using said new set of input data in the creation of the model.

The invention thus provides a self-learning model that captures relationships between operating conditions and performance measurement of equipment on board. The model can learn the dependencies between a performance variable and the operating conditions automatically during the operation without any human effort. Once the model can predict the consumer behavior to the extent that is considered sufficient, the model can start analyzing performance of the equipment.

In step 10, the updated model is used to analyze the impact of an input parameter to the performance variable.

By normalizing the effect of operating conditions from the consumer measurements in the model, e.g. performance degradation due to equipment wear or poor operation can be spotted easily.

As was indicated, steps 5 - 8 are repeated only if quality criteria are not met. Thus, even the initial model can in theory be used to evaluate the performance if the quality criteria are fulfilled already after the first comparison in step 9.

Step 10 is performed by using the model to isolate the effect of each input variable to the performance variable and by removing the effect of the input variables that are not interesting.

The result obtained is a normalized performance variable from which unnecessary influencing factors have been removed.

The model of the invention can thus predict the conditional distribution of the performance variable. The current measured performance variable and the conditional distribution of the performance variable can be used to compute an index that is normalized with the parameters of the conditional distribution.

In other words, it can be predicted within which range the performance variable varies in these conditions. As a simplified example, the ambient temperature varies a lot during the ship operation. If a model, that predicts the energy consumption of the ship HVAC (Heating, Ventilation and Air Conditioning), the energy consumption conditional (conditioned to the measured ambient temperature) variation range of the HVAC system in addition to the expected consumption. If for instance the expected HVAC energy consumption and its variation range in measured ambient temperature condition is object of interest. Then the measured ambient temperature is given as input to the model and the model, whereby it gives the expected HVAC consumption and the variation range in the prevailing conditions. An index can then be given, wherein the measured HVAC consumption is proportioned to the variation range. An index that can be e.g. 0 - 100 is obtained, wherein 100 means that HVAC consumes significantly less than expected and 0 that the consumption is significantly more than expected. It can in this way very quickly be seen that the when the index is close to 100 the performance and operation of the HVAC system is very good compared to the historical performance in the same operating conditions.

## Claims

1. A computer-implemented method for evaluation of the performance of a ship,
the method comprising the steps of
a) defining one or more performance variables of a ship and dynamic input parameters that affect the performance variables,
b) creating an initial model for simulating the performance of the ship by means of the performance variables and the dynamic input parameters,
c) obtaining measurement results from sensors during the operation of the ship for producing a set of new dynamic input parameters,
d) automatically learning dependencies between the performance variables and the dynamic input parameters,
e) updating the model to be used in further operation until the model meets preset quality criteria,
f) using the updated model to analyze the impact of an input parameter to a performance variable.

2. Method of claim 1, **characterized by** analyzing the impact of further input parameters to the performance variable.

3. Method of claim 1, **characterized in that** the updated model is used to evaluate the performance of a device with respect to the measurements results.

4. Method of claim 1, 2, or 3, **characterized by** removing the effect of selected conditions or factors from the measurements by means of the model and presenting an estimation for the value of the performance variable without said effect.

5. Method of claim 1, 2, 3, or 4, **characterized by** using the model to evaluate performance.

6. Method of claim 1, 2, 3, 4, or 5, **characterized by** using the model to predict the conditional distribution of the performance variable.

7. Method of claim 6, **characterized by** using the current measured performance variable and the conditional distribution of the performance variable to compute an index that is normalized with the parameters of the conditional distribution.

8. Method of claim 6 or 7, **characterized in that** the performance value is an object on process level, on apparatus level or on operation level.

9. Method of claim 1, 2, 3, 4, 5, 6, 7, or 8, **characterized in that** the performance value is the total energy consumption of the ship, the energy consumption of one or more individual devices on the ship, the power consumption of the ship, the power consumption of one or more individual devices on the ship, time of completing an operation, pressure (pressure difference, flow, temperature) in pipes, ducts and funnels, debris or cleanliness of oil or other liquid, the fuel consumption of one or more individual devices of the ship, the vibration energy of a rotating device on the ship, and resistance of operation in one or more devices of the ship, and torque or force produced by a device.

10. Method of claim 1, 2, 3, 4, 5, 6, 7, 8, or 9, **characterized in that** the dynamic input parameters consist of information about route, weather, ocean currents, speed, sea depth, ambient temperature, air humidity, vessel motion, floating position (draft, trim, list), setpoints of the propulsion and auxiliary equipment in the vessel, fuel costs, operational conditions, such as operational mode, operating hours, and emissions, or physical measurements such as rotation speed, temperature, flow, debris or cleanliness, vibration, acceleration, time, resistance, power, current, torque, force, physical load, pressure or pressure difference.

11. Method of f claims 1, 2, 3, 4, 5, 6, 7, 8, 9, or 10, further **characterized by** continuously monitoring and evaluation of the measurement data quality and reliability as well as the quality of the model and the modeling results, by ignoring measurements or estimating measurements to be some other value on the basis of information and dynamics from other measurements, foregoing values, and/or the relationships describing the measurements, if obtained measurements are evaluated to be erroneous.

12. A system in a ship for evaluation of the performance of a ship, the system
comprising
a) a processor unit having a computer model
- simulating the performance of a ship,
- defining one or more performance variables of a ship and dynamic input parameters that affect the performance variables,
- having means for automatically learning dependencies between the performance variables and the dynamic input parameters, and having
- means for continuously obtaining measurement results during the operation of the ship and for using the measurement results for producing sets of new dynamic input parameters to be used in the model instead of input parameters used earlier in the model,
- means for updating the model to be used as the model in further operation and further updating the model until the model meets preset quality criteria,
- means for analyze the impact of an input parameter to one or more performance variables, and
b) sensors signaling measurement results during the operation of the ship to the processor,

13. System of claims 12, further **characterized in that** the model have means for removing the effect of non-important input variables from the model and presenting a model that describes a normalized performance variable.

14. System of claims 12 or 13, further **characterized in that** the model have means for means for continuously monitoring and evaluation of the measurement data quality and reliability as well as the quality of the model and the modeling results.

15. System of claim 12, 13 or 14, **characterized in that** the model has means for continuously monitoring and evaluation of the measurement data quality and reliability as well as the quality of the model and the modeling results, by ignoring measurements or estimating measurements to be some other value on the basis of information and dynamics from other measurements, foregoing values, and/or the relationships describing the measurements, if obtained measurements are evaluated to be erroneous.

16. Computer program product run in a processor unit in a ship, constituting of a model simulating the operation of a ship, the model defining one or more performance variables of a ship and dynamic input parameters that affect the performance variables and performing the steps of
- automatically learning dependencies between the performance variables and the dynamic input parameters, and having
- continuously using sets of new dynamic input parameters in the simulation instead of input parameters used earlier, the new dynamic input parameters being produced from measurement results from sensors during the operation of the ship,
- updating itself until the it meet preset quality criteria preset quality criteria, and
- analyzing the impact of one or more input parameters to one or more performance variables.
